(19) **Europäisches Patentamt / European Patent Office / Office européen des brevets**

(11) **EP 1 756 857 B1**

(12) **EUROPEAN PATENT SPECIFICATION**

(45) Date of publication and mention
of the grant of the patent:
**14.08.2013 Bulletin 2013/33**

(21) Application number: **05751278.2**

(22) Date of filing: **08.06.2005**

(51) Int Cl.:
***H01L 33/00*** (2010.01)    ***B23K 26/36*** (2006.01)

(86) International application number:
**PCT/JP2005/010904**

(87) International publication number:
**WO 2005/122223 (22.12.2005 Gazette 2005/51)**

(54) **PRODUCTION METHOD OF COMPOUND SEMICONDUCTOR DEVICE WAFER**

HERSTELLUNGSVERFAHREN FÜR VERBUNDHALBLEITERWAFER

PROCÉDÉ DE PRODUCTION D'UNE PLAQUETTE DE DISPOSITIF SEMI-CONDUCTEUR ÉTANCHE

(84) Designated Contracting States:
**AT BE BG CH CY CZ DE DK EE ES FI FR GB GR HU IE IS IT LI LT LU MC NL PL PT RO SE SI SK TR**

(30) Priority: **11.06.2004 JP 2004174333**

(43) Date of publication of application:
**28.02.2007 Bulletin 2007/09**

(73) Proprietor: **SHOWA DENKO K.K.**
**Tokyo 105-8518 (JP)**

(72) Inventor: **KUSUNOKI, Katsuki**
**Ichihara-shi,**
**Chiba 2900067 (JP)**

(74) Representative: **Tack, Jens**
**Strehl Schübel-Hopf & Partner**
**Maximilianstrasse 54**
**80538 München (DE)**

(56) References cited:
| | |
|---|---|
| EP-A- 1 376 687 | GB-A- 2 303 095 |
| JP-A- 11 163 403 | JP-A- 55 074 158 |
| JP-A- 2001 203 176 | JP-A- 2004 031 526 |
| JP-A- 2004 158 859 | JP-A- 2004 228 290 |
| US-A1- 2004 029 362 | US-B1- 6 399 408 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a method for producing a semiconductor wafer, including a substrate, and a plurality of compound semiconductor devices provided on the substrate and arranged with separation zones being disposed between the compound semiconductor devices.

Background Art

Hitherto, pn-junction light-emitting diodes (LEDs) have been well known as a type of compound semiconductor device. Examples of such known LEDs include a GaP LED having a substrate, and a gallium phosphide (GaP) light-emitting layer obtained through epitaxial growth of an electrically conductive GaP single crystal atop the substrate; an LED which emits red light or orange-yellow to green light, the LED having a light-emitting layer formed of an aluminum gallium arsenide mixed crystal ($Al_XGa_YAs$: $0 \leq X$, $Y \leq 1$, and $X + Y = 1$), or formed of an aluminum gallium indium phosphide mixed crystal ($Al_XGa_YIn_ZP$: $0 \leq X$, $Y$, $Z \leq 1$, and $X + Y + Z = 1$); and a LED which emits short-wavelength light (e. g., near-ultraviolet light, blue light, or green light), the LED having a light-emitting layer formed of a Group III nitride semiconductor such as gallium indium nitride

$$(Ga_\alpha In_\beta N: \ 0 \leq \alpha, \ \beta \leq 1, \ and \ \alpha + \beta = 1).$$

In the aforementioned devices, an electrically conductive n-type or p-type light-emitting layer is formed on a substrate. For example, in an $Al_XGa_YIn_ZP$ LED, a substrate composed of an electrically conductive p-type or n-type gallium arsenide (GaAs) single crystal is employed. In a blue LED, a single crystal (e.g., an electrically insulating sapphire ($\alpha$-$Al_2O_3$) single crystal) is employed as a substrate. In a short-wavelength LED, a substrate formed of cubic (3C) or hexagonal (4H or 6H) silicon carbide (SiC) is employed.
In general, a dicer or a scriber is employed for preparing individual compound semiconductor light-emitting device chips from a compound semiconductor light-emitting device wafer including such a substrate and numerous compound semiconductor light-emitting devices, the devices being regularly and periodically arranged with separation zones being disposed between the compound semiconductor devices. A "dicer" is an apparatus for cleaving such a wafer into chips through the following procedure: the wafer is subjected to full-cleaving by means of rotation of a disk blade having a diamond tip; or grooves having a width larger than that of the blade tip are formed on the wafer (half-cleaving), and then the resultant wafer is subjected to cleaving by means of external force. Meanwhile, a "scriber" is an apparatus for cleaving such a wafer into chips through the following procedure: very thin lines are scribed on the wafer in, for example, a grid form by use of a needle whose tip is formed of diamond, and the resultant wafer is subjected to cleaving by means of external force. A crystal having a zincblende structure, such as GaP or GaAs, exhibits cleavability along a "110" plane. Therefore, by virtue of such a characteristic feature, a semiconductor wafer formed of, for example, GaAs, GaAlAs, or GaP can be relatively easily separated into chips having a desired shape.
However, a nitride semiconductor, which is to be stacked on a sapphire substrate or a similar substrate, has a heteroepitaxial structure, and has a large lattice constant mismatch with respect to the sapphire substrate. A sapphire substrate has a hexagonal system, and thus exhibits no cleavability. Sapphire and nitride semiconductor have Mohs hardnesses of about 9; i.e., they are very hard substances. Therefore, a wafer including a sapphire substrate and a nitride semiconductor is difficult to cleave into chips by use of a scriber. When such a wafer is subjected to full-cleaving by use of a dicer, cracking or chipping tends to occur on the cleaved surfaces; i.e., the wafer cannot be cleaved into chips successfully. In some cases, a semiconductor layer formed on the sapphire substrate is exfoliated therefrom.
In order to solve such problems, scribing techniques employing laser irradiation have been proposed. As has been reported, when separation grooves are formed on a compound semiconductor wafer by means of laser irradiation, semiconductor device chips are produced at high yield and productivity (see, for example, Japanese Patent No. 3449201, Japanese Patent Application Laid-Open (*kokai*) No. 11-177139 and Japanese Patent Application Laid-Open (*kokai*) No. 2004-31526). In particular, these documents disclose that when scribing is performed on a semiconductor side, an exposed portion of the substrate is scribed. However, in practice, an exposed surface of a sapphire substrate is processed at considerably low speed even when scribing is performed through laser irradiation, thereby impairing semiconductor device wafer production efficiency. In addition, during etching on a semiconductor side, at least two etching steps for exposing an n-type semiconductor layer for forming a negative electrode and for exposing the sapphire substrate for forming separation grooves must be carried out.
Further, a report has been made to the effect that when a protective film is formed on a laser processing surface and contamination deposited onto the protective film is washed away after the formation of a laser groove, Group III nitride type compound semiconductor devices can be acquired with high yield (see, for example, Japanese Patent Application Laid-Open (*kokai*) No. 2004-31526). According to this method, electric characteristics, such as the reverse breakdown voltage, can be improved and the drop of the yield resulting from defects in appearance and characteristics can be improved, but molten matter adheres to the side surface of a separation groove when the separation groove is formed by laser processing and the light emission output of the device drops.

EP 1 376 687 A discloses a method for producing a compound semiconductor device wafer, comprising forming separation grooves at parting lines on which semiconductor layers are removed so that only an electrode-forming layer on a side near the substrate remains or no semiconductor layer remains on said parting lines.

Disclosure of the Invention

An object of the present invention is to provide a method for producing a compound semiconductor device wafer, which method enables cleaving of a wafer with precision and at remarkably high yield, attains high process speed, and improves productivity.

The present invention provides the following.

(1) A method for producing a compound semiconductor device wafer, the wafer including a substrate (1) and a plurality of compound semiconductor devices (10) provided on the substrate (1) and arranged with separation zones (20) being disposed between the compound semiconductor devices (10), comprising a step of forming separation grooves (50) having a cross section having a V or a U shape, through laser processing, extending from the top surface of the substrate (1) to a specific depth into the substrate on the top surface of the substrate (1), i.e., surface on the compound semiconductor side, at the separation zones (20) under the condition that a spot shape of the laser beam is an ellipse, and a step in which portions of the compound semiconductor layer that are present in the separation zones (20) are removed, thereby forming trenches (40), under the condition that upon provision of said trenches (40) a compound semiconductor layer is present on the top surface of the substrate (1) at the separation zones (20), characterized in that the thickness of the compound semiconductor layer at the separation zones (20) from the bottom of said trenches (40) to the top of the substrate (1) is 5 $\mu$m or more.

(2) A method for producing a compound semiconductor device wafer according to (1) above, wherein the compound semiconductor is a Group III nitride semiconductor.

(3) A method for producing a compound semiconductor device wafer according to (1) or (2) above, wherein the substrate is composed of a species selected from the group consisting of sapphire, SiC, and nitride semiconductor single crystals.

(4) A method for producing a compound semiconductor device wafer according to any one of (1) to (3) above, wherein the bottom surface of the trench is at a level equal to that of a surface on which a negative electrode is formed.

(5) A method for producing a compound semiconductor device wafer according to any one of (1) to (4) above, which further comprises a step of thinning the substrate from the bottom surface of the substrate, which step is performed after the formation of the separation grooves.

(6) A method for producing a compound semiconductor device wafer according to any one of (1) to (5) above, wherein the laser processing is performed while a gas is blown onto a laser-irradiated portion.

(7) A method for producing a compound semiconductor device wafer according to any one of (1) to (6) above, wherein the depth of each of the separation grooves (50) is 6 $\mu$m or more from the top surface of the substrate (1).

(8) A method for producing a compound semiconductor device wafer according to any one of (1) to (7) above, the method further comprising a step of forming separation grooves in the bottom surface of the substrate (1).

(9) A method for producing a compound semiconductor device wafer according to any one of (1) to (8) above, wherein the cross section of each of the trenches (40) has a rectangular shape, a U shape, or a V shape.

According to the present invention, separation grooves are formed, through laser processing, in the top surface of the substrate at the separation zones under the condition that a compound semiconductor layer is present on the top surface of the substrate. Thus, separation grooves can be formed at a remarkably high processing speed. One conceivable reason for attaining high processing speed is that the compound semiconductor layer absorbs a laser beam more efficiently as compared to the substrate, whereby the separation zones including the substrate are maintained at a high temperature.

Moreover, by means of adjusting a spot shape of a laser beam optimally, molten matter on a side surface of a separation groove is reduced, thereby to provide a fine cleaved surface. Further, by means of removing a debris in the circumference of separation grooves selectively by etching, a good light extraction efficiency is attained.

In addition, as separation grooves are formed in the top surface of the substrate through the compound semiconductor layer, chipping of a light-emitting face of each of the device chips during cleaving of the wafer can be prevented.

Therefore, compound semiconductor light-emitting device chips obtained from the wafer produced through the method of the present invention exhibit excellent light extraction efficiency, and are produced at high yield and speed.

Brief Description of Drawings

Fig. 1 is a schematic plan view showing a wafer of the present invention produced in Example 1.
Fig. 2 is a schematic cross-sectional view showing the wafer of the present invention produced in Example 1.

Best Mode for Carrying Out the Invention

No particular limitation is imposed on the material of the substrate of the compound semiconductor device wafer of the present invention, and the substrate may be formed of any known material. Examples of the material include glass; oxide single crystals such as a sapphire single crystal ($Al_2O_3$; A-plane, C-plane, M-plane, or R-plane), a spinel single crystal ($MgAl_2O_4$), a ZnO single crystal, an $LiAlO_2$ single crystal, an $LiGaO_2$ single crystal, and an MgO single crystal; an SiC single crystal; an Si single crystal; a GaAs single crystal; nitride semiconductor single crystals such as an AlN single crystal and a GaN single crystal; and boride single crystals such as a $ZrB_2$ single crystal. Of these materials, a sapphire single crystal, an SiC single crystal, and nitride semiconductor single crystals are preferred, with a sapphire single crystal being particularly preferred. No particular limitation is imposed on the crystal orientation of the substrate. The crystal plane of the substrate may be inclined toward to a specific crystal plane or not inclined.

The substrate to be employed is generally cleaved out of a single crystal ingot so as to have a thickness of 250 to 1 000 $\mu$m. Compound semiconductor layers are stacked on the substrate having a thickness falling within the above range, and the substrate is thinned through polishing. Subsequently, the separation grooves may be formed. Alternatively, separation grooves are formed, followed by polishing of the substrate for thinning thereof. The thickness of the substrate after polishing is preferably 150 $\mu$m or less, more preferably 100 $\mu$m or less. This is because, when the substrate thickness is decreased, the cleaving distance can be reduced, whereby the wafer can be reliably cleaved into chips at the positions of the separation grooves.

The semiconductor layer has a thickness of 5 $\mu$m or more, and the substrate is preferably thinned through polishing the bottom surface of the substrate after formation of separation grooves. When the semiconductor layer is thicker, warpage of the thinned wafer tends to increase due to difference in thermal expansion coefficient between the semiconductor layer and the substrate. In this case, the semiconductor layer side protrudes. When the wafer is warped to a great extent, subsequent steps including formation of separation grooves and cleaving into device chips become difficult.

Warpage of the wafer may also be adjusted by regulating surface roughness of the bottom surface of the substrate. The larger the surface roughness Ra (arithmetical average surface roughness), the flatter the wafer. Thus, Ra is preferably 0.001 $\mu$m or more, more preferably 0.01 $\mu$m or more. However, when the Ra is excessively high, the semiconductor layer side is in contrast dented. Thus, the upper limit of Ra is preferably 2 $\mu$m or less, more preferably 0.3 $\mu$m or less.

In the present specification, Ra of the bottom surface of the substrate is a value determined by use of an atomic force microscope (product of GI) under the following conditions: image; area 30 $\times$ 30 $\mu$m, scan lines; 256, and scan rate; 1 Hz.

Examples of the compound semiconductor layer constituting the semiconductor device include a Group III nitride semiconductor layer such as an $Al_XGa_YIn_ZN_{1-a}M_a$ ($0 \leq X \leq 1$, $0 \leq Y \leq 1$, $0 \leq Z \leq 1$, and X + Y + Z = 1, wherein M represents a Group V element other than nitrogen, and a satisfies the following relation: $0 \leq a < 1$) layer, the layer being provided atop, for example, a sapphire substrate, a silicon carbide substrate, or a silicon substrate; an $Al_XGa_YAs$ ($0 \leq$ X, Y $\leq 1$, X + Y = 1) layer provided atop a gallium arsenide (GaAs) single-crystal substrate; an $Al_XGa_YIn_ZP$ ($0 \leq$ X, Y, Z $\leq 1$, X + Y + Z = 1) layer provided atop a gallium arsenide (GaAs) single-crystal layer; and a GaP layer provided atop a GaP substrate. Particularly, in the case of a Group III nitride semiconductor layer which is difficult to cleave, effects of the present invention become remarkable.

Such a compound semiconductor layer must be provided at an appropriate position atop the substrate for attaining intended performances. For example, in order to form a light-emitting section having a double hetero junction structure, n-type and p-type compound semiconductor layers are provided on the upper and lower surfaces of a light-emitting layer.

No particular limitation is imposed on the method for growing these compound semiconductor layers, and there may be employed any known method for growing a compound semiconductor layer, such as MOCVD (metal organic chemical vapor deposition), HVPE (hydride vapor phase epitaxy), or MBE (molecular beam epitaxy). From the viewpoints of layer thickness controllability and mass productivity, MOCVD is preferably employed.

In the case where Group III nitride semiconductor layers are grown by means of MOCVD, hydrogen ($H_2$) or nitrogen ($N_2$) is employed as a carrier gas, trimethylgallium (TMG) or triethylgallium (TEG) is employed as a Ga (Group III element) source, trimethylaluminum (TMA) or triethylaluminum (TEA) is employed as an Al (Group III element) source, trimethylindium (TMI) or triethylindium (TEI) is employed as an In (Group III element) source, and ammonia ($NH_3$), hydrazine ($N_2H_4$), or the like is employed as an N (Group V element) source. In addition, monosilane ($SiH_4$) or disilane ($Si_2H_6$) serving as an Si source, or an organogermane serving as a Ge source is employed as an n-type dopant, whereas a magnesium compound bis(cyclopentadienyl)magnesium ($Cp_2Mg$) or bis(ethylcyclopentadienyl)magnesium (($EtCp)_2Mg$) serving as an Mg source is employed as a p-type dopant. In the case of light-emitting devices, after the stacking of semiconductor layers of interest, a positive electrode and a negative electrode are formed on predetermined positions of the semiconductor multilayer structure. No particular limitation is imposed on the positive and negative electrodes employed in the present invention, and there may be employed a variety of positive and negative electrodes for forming a compound semiconductor light-emitting device, which electrodes have known configuration and structure. No particular limitation is imposed on the method for forming the positive and negative electrodes, and any known method such as vacuum deposition or sputtering may be employed.

Thus, a large number of compound semiconductor devices are regularly and periodically arranged on the substrate with separation zones being disposed between the devices. Subsequently, separation grooves are formed in the separation zones for cleaving the wafer into chips. In the case of light-emitting devices, the electrodes may also be provided after formation of the separation grooves.

Before formation of the separation grooves, portions of the compound semiconductor layer that are present in the separation zones may be removed, thereby forming trenches. Alternatively, after formation of the separation grooves, the trenches may be formed. Upon provision of trenches, a semiconductor layer having a thickness of at least 5 $\mu$m is left on the top surface of the substrate in order to maintain a high processing speed, which is an effect of the present invention. In the case of a light-emitting device formed by successively stacking an n-type layer, a light-emitting layer, and a p-type layer atop a substrate, preferably, trenches are provided at the same time when portions of the resultant compound semiconductor layer are removed for formation of a negative electrode on the n-type layer.

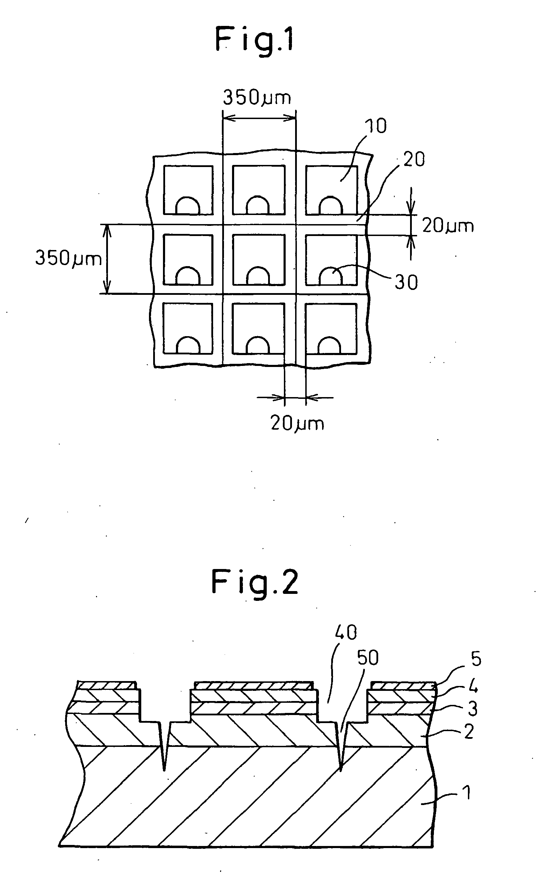

Fig. 1 is a schematic plan view showing a wafer for fabricating light-emitting devices of the present invention produced in Example 1. Reference numeral 10 denotes a light-emitting device, 20 a separation zone, and 30 a negative electrode formation surface. Fig. 2 is a schematic cross-sectional view of the wafer. Reference numeral 1 denotes a substrate, 2 an n-type layer, 3 a light-emitting layer, 4 a p-type layer, and 5 a positive electrode. A portion of the semiconductor multilayer structure present in the separation zone is removed so that the n-type layer is exposed to the outside, thereby forming a trench 40. Reference numeral 50 denotes a separation groove.

The width of each of the trenches is generally equal to that of each of the separation zones, but the trench width may be smaller than the separation zone width. However, the trench width must be greater than the width of each of the separation grooves.

No particular limitation is imposed on the depth of each of the trenches, so long as a semiconductor having a thickness falling within the aforementioned range is left on the top surface of the substrate. The trench depth, which varies depending on the thickness of the semiconductor layers, is generally about 1 to about 10 $\mu$m. Preferably, the trenches are formed such that the trench depth is regulated to a level that the n-type layer is exposed to the outside, while the negative electrode formation surface is exposed through etching. This is because the production process can then be simplified.

The cross-section of each of the trenches may assume any shape, such as a rectangular shape, a U shape, or a V shape. However, the trench preferably has a cross-section assuming a rectangular shape, from the viewpoint of formation of a separation groove on the bottom of the trench.

No particular limitation is imposed on the technique for forming the trenches, and the trenches may be formed by means of any known technique, such as etching, dicing, laser processing, and scribing. Particularly preferably, the trenches are formed by means of an etching technique such as wet etching or dry etching. This is because, etching tends not to cause damage to the top surface and side surface of the compound semiconductor layer.

In the case of dry etching, there may be employed a technique such as reactive ion etching, ion milling, focused ion beam etching, or ECR etching, whereas in the case of wet etching, for example, a mixture of sulfuric acid and phosphoric acid may be employed. Needless to say, before etching is performed, a predetermined mask is formed on the top surface of the compound semiconductor layer so as to attain a chip form of interest.

The trenches must be formed such that a compound semiconductor layer remains on the substrate. As described above, the compound semiconductor remaining on the substrate preferably has a thickness of at least 5 $\mu$m. When the semiconductor device is a light-emitting device, the compound semiconductor layer is composed of an n-type semiconductor layer, a light-emitting layer, and a p-type semiconductor layer. In this case, at least a portion of the compound semiconductor layer remains on the substrate.

Separation grooves are formed through irradiation of the compound semiconductor layer with a laser beam. As the compound semiconductor absorbs a laser beam more effectively than does the substrate, portions of the compound semiconductor layer and the substrate where separation grooves are formed are maintained at higher temperature, as compared with the case in which the substrate is exposed and is not covered with a compound semiconductor. Thus, the processing speed for forming separation grooves increases.

No particular limitation is imposed on the width of each of the separation grooves, so long as the groove width is smaller than the separation zone width. The depth of each of the separation grooves is preferably 6 $\mu$m or more from the top surface of the substrate. When the separation groove depth is smaller than 6 $\mu$m, the wafer may be cleaved obliquely into chips, which causes formation of defective chips. The separation groove depth is more preferably 10 $\mu$m or more, particularly preferably 20 $\mu$m or more.

The cross-section of each of the separation grooves has a V shape or a U shape, with a V shape being particularly preferred. This is because, when the wafer is cleaved into chips, cracking starts in the vicinity of the bottom end of the V-shaped groove, thereby reducing the percent defectives. The cross- section of the separation grooves may be controlled through regulation of a laser optical system such as a beam diameter and a focal point.

The separation grooves may be formed not only in the top surface (on the semiconductor side) but also in the bottom surface of the substrate. In this way, the wafer is reliably cleaved at the portion between the separation grooves of the top surface and those of the bottom surface, thereby reducing percent defectives. In the case in which separation grooves are also formed in the bottom surface, when the longitudinal center axis of a separation groove of the bottom surface is offset from a corresponding separation groove of the top surface, the obtained light-emitting device has a slanted side surface, which enhances light extraction efficiency.

In the present invention, separation grooves are formed through laser processing. This is because, laser processing can form separation grooves having a predetermined depth, and enables rapid formation of separation grooves, as compared with the case of etching.

In addition, as compared with the case of scribing or dicing, laser processing exhibits less variation in processing accuracy, which variation would occur as a result of wear and degradation of a cleaving blade or a diamond needle. Furthermore, laser processing enables reduction of production cost, since this technique does not require, for example, exchange of the tip of a cleaving blade.

The separation grooves formed through laser processing, which have, on their side surfaces, irregularities that can be observed under a differential interference optical microscope, enables enhancement of light extraction efficiency. In addition, the depth of each of the intersection points of the lattice-form separation grooves, the points corresponding to the corners of chips, becomes large, and thus the wafer is reliably cleaved into chips.

No particular limitation is imposed on the type of the laser processing machine to be employed in the present invention, so long as the machine can form separation grooves for separating a semiconductor wafer into chips. Specific examples of the machine which may be employed include a $CO_2$ laser, a YAG laser, an excimer laser, and a pulse laser. Of these, a pulse laser is preferred.

The wavelength of the laser beam may be, for example, 355 nm or 266 nm, and a shorter wavelength may also be employed. The laser frequency is preferably 1 to 100 000 Hz, more preferably 30 000 to 70 000 Hz. The output power, which varies depending on the width and depth of the separation grooves, is preferably a minimum value required for producing separation grooves. As the compound semiconductor effectively absorbs a laser beam, processing with a low-output-beam can be realized. Excessive laser output power may cause damage to the substrate and the compound semiconductor. Thus, in general, the output power is preferably 2 W or less, more preferably 1 W or less.

Moreover, the spot shape of a laser beam is an ellipse. In particular, it is preferable that the elliptic shape is adjusted to be long and narrow in direction of moving the laser beam. That is because a fine cleaved surface is obtained and a processing speed is enhanced, as compared with a circle. A short diameter is preferably 10 $\mu$m or less and more preferably 5 $\mu$m or less. A long diameter is preferably 10 $\mu$m or more and more preferably 50 $\mu$m or more.

In addition, when a gas is blown onto the laser-irradiated portion, the portion around the laser-irradiated portion of the compound semiconductor layer is cooled and thermal damage of the compound semiconductor layer can be reduced. Further, the molten matter generated by irradiating does not adhere to the side surface of the separation grooves but is blown off by the gas stream. Consequently, the light extraction amount from the side surface of the separation grooves can be improved. The gas to be blown onto the laser-irradiated portion includes oxygen, nitrogen, helium, argon, hydrogen, and so forth, and they can be used without any limitation. The helium, hydrogen and nitrogen have particularly a high cooling effect and can be used preferably. Among these gases, nitrogen is more preferable because it is economical. To blow the gas, a nozzle diameter at the distal end is preferably as small as possible. The smaller the nozzle diameter, better local blowing becomes possible and the gas flow velocity can be increased.

The laser beam emitted from the laser processing machine can be focused on a position of interest by means of an optical system (e. g., a lens). The laser beam is preferably focused on a portion in the vicinity of the semiconductor layer, particularly the surface of the semiconductor layer.

Formation of separation grooves through laser processing causes particularly considerable scattering of debris, as compared with the case where separation grooves are formed by means of another technique. During formation of separation grooves, such debris is deposited on the top surface of the semiconductor wafer and the bottom surface of the wafer (when separation grooves are formed in the bottom surface). The debris was found to contain at least one element selected from among Al, O, C, Cl, Si, and the like as a result of EDX analysis by use of an electron microscope (FE-SEM).

In a preferred manner, the protective film is provided on the surface on which separation grooves are formed before formation of the separation grooves, and after formation of separation grooves, debris deposited on the protective film is removed along with the protective film itself. When the trenches are formed, the protective film is provided after formation of the trenches.

No particular limitation is imposed on the material of the protective film, and the film may be formed of, for example, resist, transparent resin, glass, metal, or insulating film. Examples of the resist include a water-soluble resist employed for photolithography, and so on. Examples of the transparent resin include acrylic resin, polyester, polyimide, polyvinyl chloride, and silicone resin. Examples of the metal include nickel and titanium. Examples of the insulating film include silicon oxide film and silicon nitride film. The protective film can be formed by means of a known technique such as application, vapor deposition, or sputtering.

No particular limitation is imposed on the thickness of the protective film, so long as the film has enough strength to prevent the film from being damaged during formation of the separation grooves. The minimum thickness of the protective film is preferably 0.001 $\mu$m or more, more preferably 0.01 $\mu$m or more. In the case where the thickness of the protective film is excessively large, when the separation grooves are formed through, for example, laser processing, the protective film may absorb a laser beam and may be exfoliated from the wafer. Therefore, the maximum thickness of the protective film is preferably 5 $\mu$m or less, more preferably 3 $\mu$m or less, particularly preferably 1 $\mu$m or less.

After formation of the separation grooves, the protective film and debris deposited on the surface thereof are removed. No particular limitation is imposed on the technique for removing the protective film, so long as the protective film can be removed completely. The protective film may be removed by means of any technique, such as ultrasonic treatment, water jet treatment, showering, immersion, etching, or scrubbing.

A water-soluble resist is preferably employed, as a protective film having a uniform thickness can be formed from the resist by use of a spin coater so as to cover the entire surface of the semiconductor wafer, and the resist film can be readily removed through washing with water after formation of the separation grooves.

When a photoresist is employed as the protective film, it is preferable that, after forming separation grooves, the wafer is immersed in a phosphoric acid, sulfuric acid, hydrochloric acid and so on, debris around the separation grooves is selectively removed by the wet etching and then the photoresist on the wafer surface is completely removed using an organic solvent such as, for example, acetone and so on.

In the case where the protective film is formed of an insulating film, preferably, the protective film is partially removed such that the film remains on the trenches of the semiconductor wafer, as a short circuit between the positive and negative electrodes is prevented. In this case, preferably, the protective film is formed of a transparent, insulating film. In the case of such partial removal of the protective film, the film may be subjected to selective etching by use of an etching mask.

Examples

The present invention will next be described in more detail by way of Examples, which should not be construed as limiting the invention thereto.

<Example 1>

A blue-light-emitting device including a gallium-nitride-based compound semiconductor was produced as follows.

An AlN buffer layer was formed on a sapphire substrate. On the AlN buffer layer were successively stacked an underlying layer (thickness: 2 $\mu$m) composed of undoped GaN; an n-contact layer (thickness: 2 $\mu$m) composed of GaN doped with Si (concentration: $1 \times 10^{19}$/cm$^3$); an n-cladding layer (thickness: 12.5 nm) composed of In$_{0.1}$Ga$_{0.9}$N doped with Si (concentration: $1 \times 10^{18}$/cm$^3$); a light-emitting layer having a multiple quantum well structure, which was formed by alternately stacking five GaN barrier layers (thickness: 16 nm each) and five In$_{0.2}$Ga$_{0.8}$N well layers (thickness: 2.5 nm each), and then providing a GaN barrier layer (thickness: 16 nm) on the uppermost well layer; a p-cladding layer (thickness: 2.5 nm) composed of Al$_{0.07}$Ga$_{0.93}$N doped with Mg (concentration: $1 \times 10^{20}$/cm$^3$); and a p-contact layer (thickness: 0.15 $\mu$m) composed of GaN doped with Mg (concentration: $8 \times 10^{19}$/cm$^3$), to thereby produce a compound semiconductor multilayer structure.

A transparent positive electrode having a multilayer structure including an Au layer and an NiO layer was formed on a predetermined position of the p-contact layer of the above-produced compound semiconductor multilayer structure. Specifically, the positive electrode was formed by successively stacking the Au layer and the NiO layer on the p-contact layer by means of known photolithography and lift-off techniques. Subsequently, by means of a known photolithography technique, there was formed a positive electrode bonding pad having a multilayer structure including a Ti layer, an Al layer, a Ti layer, and an Au layer, the layers being successively provided on the positive electrode in this order.

The above-formed transparent positive electrode was found to have a transmittance of 60% for light of 470 nm. The transmittance was measured by use of a transparent positive electrode formed through the above-described procedure, whose size was regulated to meet transmittance measurement requirements.

Subsequently, separation zones shown in Fig. 1 (pitch: 350 $\mu$m, width: 20 $\mu$m) were subjected to etching by means of known photolithography and reactive ion etching techniques to a depth of 1 $\mu$m, thereby forming trenches. Meanwhile, as shown in Fig. 1, a portion of each of the compound semiconductor multilayer structures that faces a separation zone was subjected to etching, to thereby expose the n-contact layer to the outside and form a semicircular negative electrode formation surface (30). Subsequently, a negative electrode having a Ti/Au two-layer structure was formed on the negative electrode formation surface by means of a method known to those skilled in the art.

Thereafter, a water-soluble resist was uniformly applied to the entire surface of the semiconductor multilayer structure of the semiconductor wafer by use of a spin coater, followed by drying, to thereby form a protective film having a thickness of 0.2 $\mu$m.

Subsequently, a UV tape was attached to the sapphire substrate of the semiconductor wafer, and then the wafer was fixed on a stage of a pulse laser processing machine by means of a vacuum chuck. The stage is movable in the X-axis and Y-axis directions, and is rotatable. After fixation of the wafer, a laser optical system was controlled such that a laser beam was focused on the bottom surface of the semiconductor layer in the trenches, and separation grooves (pitch: 350 $\mu$m, width: 5 $\mu$m, depth from the top surface of the substrate: 20 $\mu$m) having a V-shaped cross-section were formed in the bottom surfaces of the trenches in the X-axis direction of the sapphire substrate. The laser processing was performed under the following conditions: wavelength; 266 nm, frequency; 50 kHz, and output power; 1.6 W. Under these conditions, high-quality separation grooves were formed at a processing speed of 70 mm/sec. Subsequently, the stage was rotated by 90°, and separation grooves were formed in the Y-axis direction in a manner similar to that described above. After formation of the separation grooves, the vacuum chuck was released, and the resultant wafer was removed from the stage.

Subsequently, the semiconductor wafer was placed on a stage of a washing machine, and water was showered onto the surface of the semiconductor multilayer structure while the wafer was rotated, to thereby remove the above-formed protective film. Finally, the resultant wafer was rotated at high speed, to thereby blow off the water to dry the wafer.

The bottom surface of the sapphire substrate of the thus-produced compound semiconductor light-emitting device wafer was subjected to lapping and polishing, to thereby reduce the thickness of the substrate to 85 $\mu$m. The bottom surface of the substrate was found to have an Ra of 0.005 $\mu$m.

The resultant compound semiconductor light-emitting device wafer was subjected to visual inspection, and no debris were observed on the surface of the wafer. The wafer was cleaved into a number of light-emitting device chips (each having a size of 350 $\mu$m $\times$ 350 $\mu$m) through application of pressure to the sapphire substrate. The yield of device chips (products with defective appearance were not included, having been rejected in advance) was found to be 90%. Furthermore, the yield of device chips (products with defective appearance and high breakdown voltage were not included, having been rejected in advance) was found to be 86%.

Emission output of the chip-mounted light-emitting device before molding with resin as determined by use of an integrating sphere was found to be 5.1 mW at a current of 20 mA.

<Comparative Example 1>

The procedure of Example 1 was repeated, except that the step of forming trenches in the separation zones through etching of a semiconductor layer was performed through two steps; i.e., a first step of forming a negative electrode formation surface and exposing the n-contact layer in the separation zones, and a second step of exposing the sapphire substrate in the separation zones so as to form trenches, to thereby fabricate compound semiconductor light-emitting device chips. The thus-produced light-emitting device chips exhibited quality equivalent to that of the device chips produced in Example 1. However, the processing speed was reduced to 40 mm/sec so as to form separation grooves having a depth of 20 $\mu$m. Thus, the number of wafers that can be processed per hour was decreased by about 40%. In addition, the step of etching for exposing the sapphire substrate required about 4 hours.

<Example 2>

The procedure of Example 1 was repeated, except that the thickness of the undoped GaN underlying layer included in the compound semiconductor stacked structure was controlled to 8 $\mu$m, to thereby fabricate a blue-light-emitting device composed of a gallium-nitride-based compound semiconductor. In Example 2, separation grooves having a depth (from the top surface of the substrate) of 20 $\mu$m were efficiently formed at a processing speed of 70 mm/sec. Light-emitting device chips exhibiting quality equivalent to that of the device chips produced in Example 1 were produced at the same yield.

In Example 2, when the substrate was thinned before formation of separation grooves, the substrate was warped, and a laser beam could not be consistently focused on the semiconductor surface. Thus, the compound semiconductor layer was partially damaged by heat. In addition, when the thus-produced wafer was cleaved into chips, cracking occurred, thereby reducing the final yield to 70%. In contrast, when Ra of the bottom surface of the substrate was adjusted to 0.015 $\mu$m during thinning of the substrate, warpage of the substrate was reduced, and light-emitting device chips exhibiting quality equivalent to that of the device chips produced in Example 1 were produced at the same yield.

Notably, in Example 1, the compound semiconductor layer was thin. Thus, even when the substrate was thinned before formation of separation grooves, the substrate was not warped, and quality and production yield of the light-emitting devices were not impaired.

Industrial Applicability

According to the method of the present invention, a compound semiconductor device wafer can be processed at a remarkably improved speed. Therefore, the present invention has very high industrial utility value in the production of compound semiconductor devices.

**Claims**

1. A method for producing a compound semiconductor device wafer, the wafer including a substrate (1) and a plurality of compound semiconductor devices (10) provided on the substrate (1) and arranged with separation zones (20) being disposed between the compound semiconductor devices (10), comprising a step of forming separation grooves (50) having a cross section having a V or a U shape, through laser processing, extending from the top surface of the substrate (1) to a specific depth into the substrate on the top surface of the substrate (1), i.e., surface on the compound semiconductor side, at the separation zones (20) under the condition that a spot shape of the laser beam is an ellipse, and a step in which portions of the compound semiconductor layer that are present in the separation zones (20) are removed, thereby forming trenches (40), under the condition that upon provision of said trenches (40) a compound semiconductor layer is present on the top surface of the substrate (1) at the separation zones (20), **characterized in that** the thickness of the compound semiconductor layer at the separation zones (20) from the bottom of said trenches (40) to the top of the substrate (1) is 5 $\mu$m or more.

2. A method for producing a compound semiconductor device wafer according to claim 1, wherein the compound semiconductor is a Group III nitride semiconductor.

3. A method for producing a compound semiconductor device wafer according to claim 1 or 2, wherein the substrate (1) is composed of a species selected from the group consisting of sapphire, SiC, and nitride semiconductor single crystals.

4. A method for producing a compound semiconductor device wafer according to any one of claims 1-3, wherein the bottom surface of the trench (40) is at a level equal to that of a surface on which a negative electrode (30) is formed.

5. A method for producing a compound semiconductor device wafer according to any one of claims 1 to 4, which further comprises a step of thinning the substrate (1) from the bottom surface of the substrate (1), which step is performed after the formation of the separation grooves (50).

6. A method for producing a compound semiconductor device wafer according to any one of claims 1 to 5, wherein the laser processing is performed while a gas is blown onto a laser-irradiated portion.

7. A method for producing a compound semiconductor device wafer according to any one of claims 1 to 6, wherein the depth of each of the separation grooves (50) is 6 $\mu$m or more from the top surface of the substrate (1).

8. A method for producing a compound semiconductor device wafer according to any one of claims 1 to 7, the method further comprising a step of forming separation grooves in the bottom surface of the substrate (1).

9. A method for producing a compound semiconductor device wafer according to any one of claims 1 to 8, wherein the cross section of each of the trenches (40) has a rectangular shape, a U shape, or a V shape.

**Patentansprüche**

1. Verfahren zur Herstellung eines Verbindungshalbleitervorrichtungs-Wafers, wobei der Wafer ein Substrat (1) und eine Vielzahl von Verbindungshalbleitervorrichtungen (10) aufweist, die auf dem Substrat (1) vorgesehen sind und mit Trennzonen (20) angeordnet sind, welche sich zwischen den Verbindungshalbleitervorichtungen (10) befinden, umfassend einen Schritt des Ausbildens von Trennvertiefungen (50) mit einem Querschnitt mit einer V- oder U-Form mittels Laserbearbeitung, welche von der oberen Oberfläche des Substrats (1) bis zu einer bestimmten Tiefe in das Substrat hinein verlaufen, auf der oberen Oberfläche des Substrats (1), d.h. der Oberfläche auf der Verbindungshalbleiterseite, an den Trennzonen (20), unter der Bedingung, dass die Lichtfleckform des Laserstrahls eine Ellipse ist, und einen Schritt, bei dem Bereiche der Verbindungshalbleiterschicht, welche sich in den Trennzonen (20) befinden, entfernt werden, wodurch Gräben (40) gebildet werden, unter der Bedingung, dass beim Vorsehen der Gräben (40) eine Verbindungshalbleiterschicht auf der oberen Oberfläche des Substrats (1) an den Trennzonen (20) vorliegt, **dadurch gekennzeichnet, dass** die Dicke der Verbindungshalbleiterschicht an den Trennzonen (20) ab dem Boden der Gräben (40) bis zur Oberseite des Substrats (1) 5 $\mu$m oder mehr ist.

2. Verfahren zur Herstellung eines Verbindungshalbleitervorrichtungs-Wafers nach Anspruch 1, wobei der Verbindungshalbleiter ein Gruppe III-Nitridhalbleiter ist.

3. Verfahren zur Herstellung eines Verbindungshalbleitervorrichtungs-Wafers nach Anspruch 1 oder 2, wobei das Substrat (1) aus einem Kandidaten gebildet ist, ausgewählt aus der Gruppe, bestehend aus Saphir, SiC und Nitridhalbleitereinkristallen.

4. Verfahren zur Herstellung eines Verbindungshalbleitervorrichtungs-Wafers nach einem der Ansprüche 1-3, wobei die untere Oberfläche des Grabens (40) auf einer gleichen Höhe ist wie die Oberfläche, auf welcher eine negative Elektrode (30) gebildet wird.

5. Verfahren zur Herstellung eines Verbindungshalbleitervorrichtungs-Wafers nach einem der Ansprüche 1 bis 4, welches weiterhin einen Schritt des Ausdünnens des Substrats (1) von der Bodenseite des Substrats (1) umfasst, wobei dieser Schritt nach Bildung der Trennvertiefungen (50) durchgeführt wird.

6. Verfahren zur Herstellung eines Verbindungshalbleitervorrichtungs-Wafers nach einem der Ansprüche 1 bis 5, wobei die Laserbearbeitung durchgeführt wird, während ein Gas auf einen laserbestrahlten Bereich geblasen wird.

7. Verfahren zur Herstellung eines Verbindungshalbleitervorrichtungs-Wafers nach einem der Ansprüche 1 bis 6, wobei die Tiefe jeder der Trennvertiefungen (50) 6 $\mu$m oder mehr ab der oberen Oberfläche des Substrats (1) ist.

8. Verfahren zur Herstellung eines Verbindungshalbleitervorrichtungs-Wafers nach einem der Ansprüche 1 bis 7, wobei das Verfahren weiterhin einen Schritt des Ausbildens von Trennvertiefungen in der unteren Oberfläche des Substrats (1) umfasst.

9. Verfahren zur Herstellung eines Verbindungshalbleitervorrichtungs-Wafers nach einem der Ansprüche 1 bis 8, wobei der Querschnitt jeder der Gräben (40) eine rechteckige Form, eine U-Form oder eine V-Form hat.

**Revendications**

1. Procédé pour produire une galette de dispositifs à composé semi-conducteur, la galette comprenant un substrat (1) et une pluralité de dispositifs à composé semi-conducteur (10) disposés sur le substrat (1) et agencés avec des zones de séparation (20) qui sont disposées entre les dispositifs à composé semi-conducteur (10), comprenant une étape consistant à former des rainures de séparation (50) ayant une section transversale en forme de V ou de U, par traitement au laser, s'étendant depuis la surface supérieure du substrat (1) jusqu'à une profondeur spécifique dans le substrat sur la surface supérieure du substrat (1), c'est-à-dire la surface du côté du composé semi-conducteur, au niveau des zones de séparation (20) dans des conditions dans lesquelles la forme de la tache du faisceau laser est une ellipse, et une étape dans laquelle des parties de la couche de composé semi-conducteur qui sont présentes dans les zones de séparation (20) sont retirées, en formant ainsi des sillons (40), dans des conditions dans lesquelles, lorsque lesdits sillons (40) ont été formés, une couche de composé semi-conducteur est présente sur la surface supérieure du substrat (1) au niveau des zones de séparation (20), **caractérisé en ce que** l'épaisseur de la couche de composé semi-conducteur au niveau des zones de séparation (20) depuis le fond desdits sillons (40) jusqu'en haut du substrat (1) est de 5 μm ou plus.

2. Procédé pour produire une galette de dispositifs à composé semi-conducteur selon la revendication 1, dans lequel le composé semi-conducteur est un semi-conducteur de type nitrure d'un élément du Groupe III.

3. Procédé pour produire une galette de dispositifs à composé semi-conducteur selon la revendication 1 ou 2, dans lequel le substrat (1) est composé d'une espèce choisie dans le groupe constitué par le saphir, SiC, et les monocristaux semi-conducteurs de type nitrure.

4. Procédé pour produire une galette de dispositifs à composé semi-conducteur selon l'une quelconque des revendications 1 à 3, dans lequel la surface inférieure du sillon (40) est à un niveau identique à celui d'une surface sur laquelle une électrode négative (30) est formée.

5. Procédé pour produire une galette de dispositifs à composé semi-conducteur selon l'une quelconque des revendications 1 à 4, qui comprend en outre une étape consistant à amincir le substrat (1) à partir de la surface inférieure du substrat (1), laquelle étape est effectuée après la formation des rainures de séparation (50).

6. Procédé pour produire une galette de dispositifs à composé semi-conducteur selon l'une quelconque des revendications 1 à 5, dans lequel le traitement au laser est effectué cependant qu'un gaz est soufflé sur une partie irradiée par le laser.

7. Procédé pour produire une galette de dispositifs à composé semi-conducteur selon l'une quelconque des revendications 1 à 6, dans lequel la profondeur de chacune des rainures de séparation (50) est de 6 μm ou plus à partir de la surface supérieure du substrat (1).

8. Procédé pour produire une galette de dispositifs à composé semi-conducteur selon l'une quelconque des revendications 1 à 7, lequel procédé comprend en outre une étape consistant à former des rainures de séparation dans la surface inférieure du substrat (1).

9. Procédé pour produire une galette de dispositifs à composé semi-conducteur selon l'une quelconque des revendications 1 à 8, dans lequel la section transversale de chacun des sillons (40) a une forme rectangulaire, une forme de U, ou une forme de V.

# Fig.1

# Fig.2

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3449201 B
- JP 11177139 A
- JP 2004031526 A
- EP 1376687 A